# EUROPEAN PATENT APPLICATION

(11) **EP 4 568 429 A1**
(43) Date of publication of application: **11.06.2025**
(21) Application number: 24211008.8
(22) Date of filing: 06.11.2024
(51) Int. Cl.: H05K 1/11, G11C 5/04, H01R 12/72

(54) **MEMORY MODULE AND ELECTRONIC DEVICE ASSEMBLY INCLUDING THE SAME**

(30) Priority: 08.12.2023 KR 20230178094
(71) Applicant: Samsung Electronics Co., Ltd., Suwon-si, Gyeonggi-do 16677 (KR)
(72) Inventor: SEO, Dongyoon, 16677 Suwon-si (KR); KIM, Dohyung, 16677 Suwon-si (KR); MOON, Jiyoon, 16677 Suwon-si (KR); LEE, Wonseop, 16677 Suwon-si (KR); CHO, Yejin, 16677 Suwon-si (KR); CHOI, Sewoong, 16677 Suwon-si (KR); HEO, Daae, 16677 Suwon-si (KR)
(74) Representative: Marks & Clerk LLP

(57) **Abstract**

Disclosed is a memory module comprising a module printed circuit board including a chip region and a pad region and a memory chip provided on the module printed circuit board in the chip region. The module printed circuit board includes a board including a first surface and a second surface disposed opposite to each other, a first pad provided on the first surface in the pad region, and a second pad provided on the second surface in the pad region. The first pad is disposed farther from the chip region than the second pad.

## Description

### BACKGROUND

The present disclosure relates generally to a memory module and an electronic device assembly.

A computing system includes a memory module including memory elements such as DRAM and SRAM. The memory module is installed on the motherboard or mainboard and connects to other components within the computing system. A socket into which the memory module is inserted is provided between the memory module and the motherboard or mainboard.

The memory module is manufactured according to various standards. For example, there are types of memory modules such as Small Outline Dual In-Line Memory Module (SODIMM) and Compression Attached Memory Module. Since various types of memory modules have different ways of connecting to sockets, a memory module suitable for each method is required.

### SUMMARY

One or more example embodiments provide a memory module and electronic device assembly with improved characteristics.

According to an embodiment, a memory module comprises a module printed circuit board including a chip region and a pad region; and a memory chip provided on the module printed circuit board in the chip region. The module printed circuit board includes a board including a first surface and a second surface disposed opposite to each other, a first pad provided on the first surface in the pad region, and a second pad provided on the second surface in the pad region. The first pad is disposed farther from the chip region than the second pad.

The first surface and the second surface are surfaces of the module printed circuit board.

The memory module may comprise vias and conductive lines formed in the board and connecting the first pad to the memory chip.

The first pad may be disposed at a position shifted from the second pad along an arrangement direction of the chip region and the pad region. The arrangement direction may be a direction parallel to a line drawn between the chip region and the pad region.

The first pad may have a pair of first width sides extending along a second direction that is perpendicular to a first direction parallel to an arrangement direction of the chip region and the pad region.

The board may be disposed in the pad region. In other words, part of the board includes the pad region. The board has a reference side extending along the second direction. The reference side may extend along a side of the pad region.

According to an embodiment, an electronic device assembly comprises a main printed circuit board; a memory module; and a connector provided between the main printed circuit board and the memory module. The memory module includes a module printed circuit board including a chip region and a pad region, and a memory chip provided on the module printed circuit board in the chip region. The module printed circuit board includes a first surface provided on one side of the main printed circuit board, a second surface opposite to the first surface and facing the main printed circuit board, a plurality of first pads provided on the first surface in the pad region, and a plurality of second pads provided on the second surface in the pad region. The plurality of first pads is disposed farther from the chip region than the plurality of second pads.

According to an embodiment, a memory module comprises a board having a first surface and a second surface disposed opposite each other; a memory chip provided on the first surface; and a plurality of first pads provided on the second surface and overlapping the memory chip along an arrangement direction of the first surface and the second surface. Some of the plurality of first pads have an area smaller than an area of others of the plurality of first pads.

Additional aspects will be set forth in part in the description which follows and, in part, will be apparent from the description, or may be learned by practice of the presented embodiments.

At least some of the above and other features of the invention are set out in the claims.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a block diagram illustrating a computing system according to example embodiments.
FIG. 2 is a top view of a memory module according to example embodiments.
FIG. 3 is a bottom view of the memory module of FIG. 2.
FIG. 4 is a cross-sectional view taken along line A-A' in FIG. 2.
FIG. 5A is a cross-sectional view illustrating an electronic device assembly including the memory module of FIG. 2.
FIGS. 5B and 5C are cross-sectional views showing a process in which the memory module of FIG. 5A is mounted on the first connector.
FIG. 6 is a top view of a memory module according to example embodiments.
FIG. 7 is a bottom view of the memory module of FIG. 6.
FIG. 8 is a top view of a memory module according to example embodiments.
FIG. 9 is a bottom view of the memory module of FIG. 8.
FIG. 10 is a top view of a memory module according to example embodiments.
FIG. 11 is a bottom view of a memory module of FIG. 10.
FIG. 12 is an enlarged view of portion AA of FIG. 11.
FIG. 13 is a cross-sectional view taken along line B-B' in FIG. 10.
FIG. 14 is a cross-sectional view for illustrating an electronic device including the memory module of FIG. 10.
FIG. 15 is a cross-sectional view for illustrating an electronic device according to example embodiments.
FIG. 16 is an enlarged view of portion BB in FIG. 15.

### DETAILED DESCRIPTION

Hereinafter, example embodiments are described in detail with reference to the accompanying drawings. Like components are denoted by like reference numerals throughout the specification, and repeated descriptions thereof are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, or as "contacting" or "in contact with" another element (or using any form of the word "contact"), there are no intervening elements or layers present.

Embodiments described herein are example embodiments, and thus, the present disclosure is not limited thereto, and may be realized in various other forms. Each example embodiment provided in the following description is not excluded from being associated with one or more features of another example or another example embodiment also provided herein or not provided herein but consistent with the present disclosure. It will be also understood that, even if a certain step or operation of manufacturing an apparatus or structure is described later than another step or operation, the step or operation may be performed later than the other step or operation unless the other step or operation is described as being performed after the step or operation.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

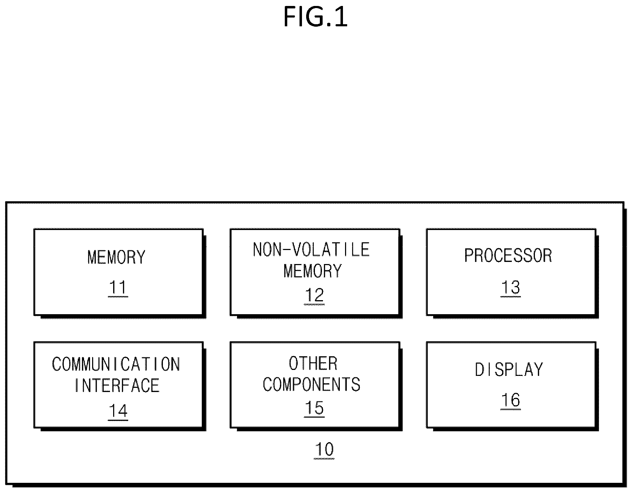

FIG. 1 is a block diagram illustrating a computing system according to example embodiments.

Referring to FIG. 1, a computing system 10 may be provided. For example, the computing system 10 may include user equipment, computers, personal computers (PCs), desktop computers, laptop computers, notebook computers, netbook computers, tablets, smartphones, embedded electronics, game consoles, server arrays or server farms, web servers, network servers, internet servers, workstations, mini computers, mainframe computers, super computers, network devices, web devices, distributed computing systems, multiprocessor systems, processor-based systems, or a combination thereof. The computing system 10 may include a main printed circuit board on which components may be mounted. The computing system 10 may include a processor 13. The processor 13 may include a central processing unit (CPU). The central processing unit may include a plurality of general-purpose processing cores. The processor 13 may include a graphics processing unit (GPU) or other processing unit. The processor 13 may include memory management logic (e.g., a memory controller) and I/O control logic.

The computing system 10 may include a memory 11 (e.g., a system memory). The system memory may be in the same package as the processor 13 or may be separate from the processor 13. In example embodiments, the memory 11 may include static random access memory (SRAM), dynamic random access memory (DRAM), or a combination thereof. In example embodiments, the memory 11 may include byte-addressable non-volatile memory, such as single- or multi-level phase change memory (PCM) or phase change memory with a switch (PCMS), non-volatile memory using chalcogenide phase change materials, resistive memory including metal oxide-based materials, resistive memory oxygen vacancy-based materials, and conductive bridge random access memory (CB-RAM), nanowire memory, ferroelectric random access memory (FeRAM, FRAM), magnetoresistive random access memory (MRAM) with memristor technology, spin transfer torque (STT)-MRAM, spintronic magnetic junction memory-based devices, magnetic tunneling junction (MTJ)-based devices, Domain Wall (DW) and Spin Orbit Transfer (SOT)-based devices, thyristor-based memory devices, or a combination thereof.

The computing system 10 may include communication interfaces 14, a display (e.g., touch screen, flat panel) 16, and other components 15. The computing system 10 may include logic and/or features to support the communication interfaces 14. In example embodiments, the communication interfaces may include one or more input/output (I/O) interfaces that operate in accordance with various communication protocols or standards to communicate directly or via network communication links or channels. Direct communications may occur through the use of communication protocols or standards described in one or more industry standards (including successor standards and variations). For example, the I/O interfaces may be a Serial Advanced Technology Attachment (SATA) interface to couple elements of the node to a storage device, a Serial Attached Small Computer System Interface (SCSI) to couple other elements of the node (e.g., a controller, or other elements of the node) to a storage device, Peripheral Component Interconnect Express (PCIe), or Non-Volatile Memory Express (NVMe) interface. The Communication interfaces may include a local wired point-to-point link (e.g., USB) interface, a wireless local area network (e.g., WiFi) interface, a wireless point-to-point link (e.g., Bluetooth) interface, a global positioning system interface, and/or other interfaces. Although not illustrated, other components may include, for example, a power supply (e.g., a battery or/and other power supply), sensors, power management logic, or other components.

The computing system 10 may include a non-volatile memory 12. In example embodiments, the non-volatile memory 12 may be a mass storage component. The non-volatile memory 12 may include byte- or block-addressable non-volatile memory. For example, the non-volatile memory 12 may include NAND flash memory (e.g., multi-threshold level NAND), NOR flash memory, single- or multi-level phase change memory (PCM), resistive memory, nanowire memory, ferroelectric transistor random access memory (FeTRAM), magnetoresistive random access memory (MRAM) with memristor technology, spin transfer torque MRAM (STT-MRAM), memory structures comprising chalcogenide materials and/or phase change materials, or a combination thereof. In example embodiments, the non-volatile memory 12 may be arranged or configured as a solid state drive (SSD). Data may be read and written in blocks. Mapping or location information for the blocks may be maintained in the memory 11.

In example embodiments, the computing system 10 may include one or more accelerators or other computing devices. For example, the computing system 10 may include an artificial intelligence (AI) or machine learning accelerator optimized to perform operations on machine learning algorithms, a graphics accelerator (e.g., GPU), or other type of accelerator. The accelerator may include processing circuitry (analog, digital, or both). The accelerator may include memory within the same package as the accelerator. Accelerators may be mounted on cards to be inserted into connectors such as the connectors described herein.

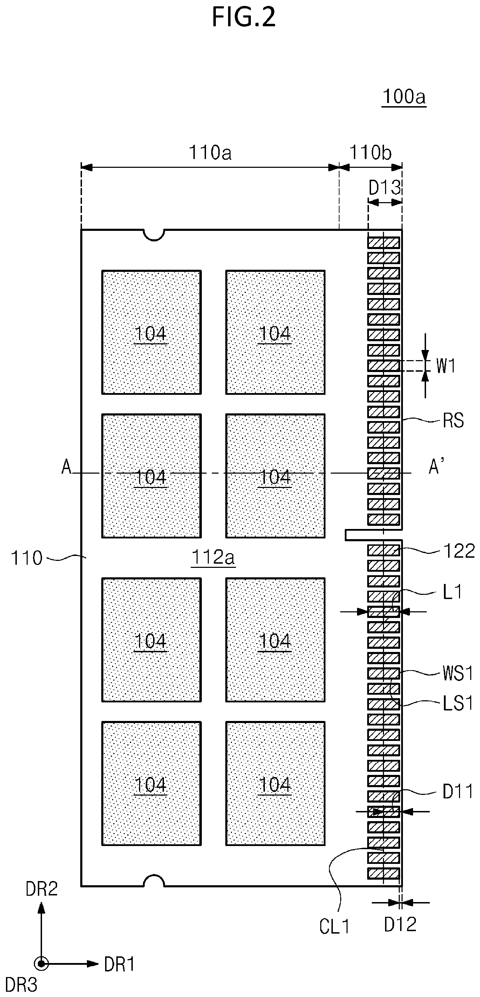

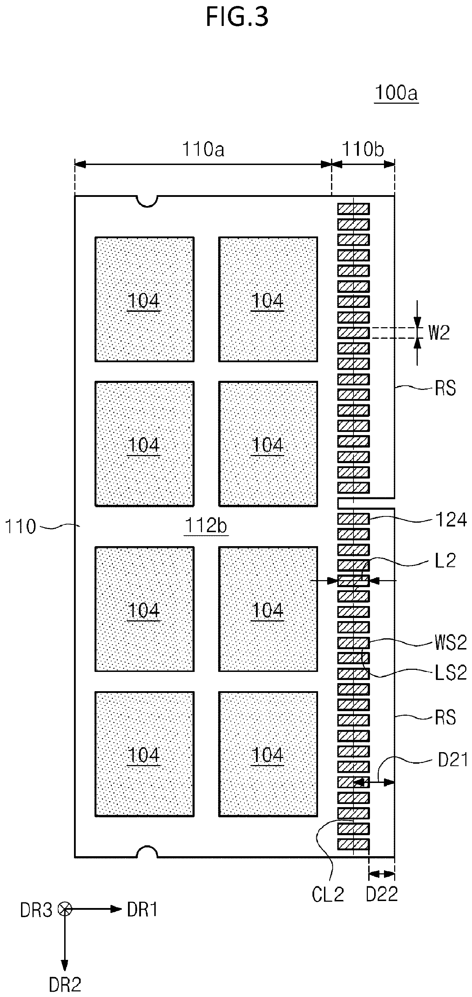

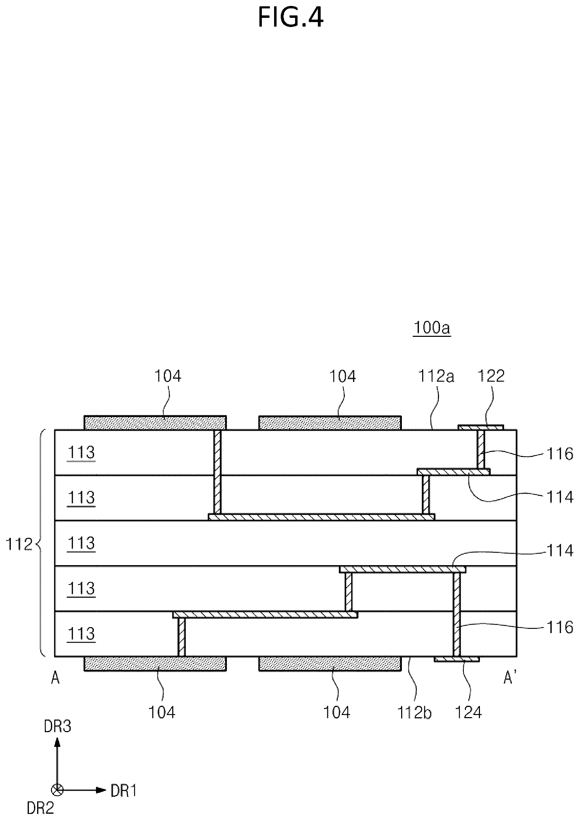

FIG. 2 is a top view of a memory module according to example embodiments. FIG. 3 is a bottom view of the memory module of FIG. 2. FIG. 4 is a cross-sectional view taken along line A-A' in FIG. 2.

Referring to FIGS. 2 to 4, a memory module 100a may be provided. In example embodiments, the memory module 100a may be used in a compact computing system, such as a laptop. The memory module 100a may include a small outline dual in-line memory module (SODIMM). The memory module 100a may include a module printed circuit board 110 and memory chips 104. The memory chips 104 may be semiconductor memory chips 104. The memory chips 104 may be provided on the module printed circuit board 110. The memory chips 104 may include, for example, DRAM, SRAM, or NAND flash memory. Some of the memory chips 104 may be mounted on a front surface of the module printed circuit board 110. The front surface of the module printed circuit board 110 may be a first surface 112a of a board 112 described below. Others of the memory chips 104 may be mounted on a back surface of the module printed circuit board 110. The back surface of the module printed circuit board 110 may be a second surface 112b of the board 112. For example, the memory chips 104 may be mounted on the module printed circuit board 110 using surface mount technology (SMT) or through-hole technology (THT).

The module printed circuit board 110 may include the board 112, conductive lines 114, vias 116, first pads 122, and second pads 124. The module printed circuit board 110 may include a chip region 110a and a pad region 110b. The chip region 110a may be a region where memory chips 104 are provided. The pad region 110b may be a region where the first pads 122 and the second pads 124 are provided. In the description, the term 'first pad 122' may be understood to refer to one of the plurality of first pads 122, i.e. the pads 122 provided on the first surface 100b of the module printed circuit board 110. Similarly, the term 'second pad 124' may be understood to refer to one of the plurality of second pads 124, i.e. the pads 124 provided on the second surface 100c.

The board 112 may extend along a first direction DR1 and a second direction DR2. The chip region 110a and the pad region 110b may sequentially arranged along the first direction DR1. The second direction DR2 may intersect the first direction DR1. The board 112 may include the first surface 112a and the second surface 112b spaced apart from each other along a third direction DR3 that intersects the first direction DR1 and the second direction DR2. For example, the first direction DR1, the second direction DR2, and the third direction DR3 may be perpendicular to each other. In example embodiments, the board 112 may include a plurality of insulating layers 113 stacked along the third direction DR3. The board 112 may be formed of or include at least one of insulating materials having the required mechanical strength and thermal stability. For example, the board 112 may be formed of or include FR4, FR2, CEM1, CEM3, polytetrafluoroethylene (PTFE), or polyimide.

The conductive lines 114 may be provided within the board 112 or on a surface of the board 112. For example, the conductive lines 114 may be provided between the plurality of insulating layers 113. The conductive lines 114 may extend along a direction parallel to the first surface 112a. For example, the conductive lines 114 may extend the first direction DR1, the second direction DR2, or a combination direction of the first direction DR1 and the second direction DR2. The conductive line 114 may include at least one of conductive materials. For example, the conductive line 114 may be formed of or include copper (Cu) or aluminum (Al). The conductive line 114 may have a specific impedance value. The conductive lines 114 may have the required morphological characteristics (e.g., length, width, and thickness). For example, the morphological characteristics of the conductive lines 114 may be determined to prevent loss or distortion of the transmission signal. In example embodiments, the conductive lines 114 and the board 112 adjacent to each other may constitute a signal transmission line. The signal transmission line may be configured to transmit a signal. For example, the signal transmission line may transmit an input signal to the memory chip 104 provided from outside the memory module 100a and an output signal provided from the memory chip 104. In example embodiments, one conductive line 114 and the board 112 adjacent to each other may constitute one signal transmission line. In example embodiments, a plurality of conductive lines 114 and the board 112 adjacent to each other may constitute one signal transmission line. For example, the signal transmission line may include microstrip line, strip line, or coplanar waveguide. In example embodiments, the conductive lines 114 may be power transmission lines that deliver a driving voltage or a ground voltage to the memory chip 104.

The vias 116 may be provided within the board 112. The vias 116 may extend along the third direction DR3. The vias 116 may be configured to provide electrical connections between different components. The vias 116 may electrically connect the conductive lines 114 provided at different heights. The conductive lines 114 connected by the vias 116 may overlap along the third direction DR3. For example, both ends of the via 116 may contact the conductive lines 114 provided at different heights, respectively. Some of the vias 116 may electrically connect the conductive lines 114 and the memory chips 104. The conductive lines 114 and the memory chips 104 connected by those vias 116 may overlap along the third direction DR3. For example, both ends of one of the vias 116 may contact the conductive line 114 and the memory chip 104, respectively. Some of the vias 116 may electrically connect the conductive lines 114 and the first pads 122. The conductive lines 114 and the first pads 122 connected by those vias 116 may overlap along the third direction DR3. For example, both ends of one of the vias 116 may contact the conductive line 114 and the first pad 122, respectively. Others of the vias 116 may electrically connect the conductive lines 114 and the second pads 124. The conductive lines 114 and the second pads 124 connected by those vias 116 may overlap along the third direction DR3. For example, both ends of one of the vias 116 may contact the conductive line 114 and the second pad 124, respectively. The vias 116 may include an electrically conductive material. For example, the vias 116 may be formed of or include copper (Cu).

The first pads 122 may be provided on the first surface 112a of the board 112. The first pads 122 may be disposed in the pad region 110b of the module printed circuit board 110. The first pads 122 may include at least one of electrically conductive materials. For example, the first pads 122 may be formed of or include copper (Cu). The first pads 122 may be signal pads, power pads, or ground pads. The first pad 122, which is a signal pad, may be referred to as a first signal pad. The signal pad may be configured to receive an input signal to the memory chip 104, which is mounted on the first surface 112a of the board 112, provided from outside the memory module 100a or to transmit an output signal provided from the memory chip 104, which is mounted on the first surface 112a of the board 112, to the outside of the memory module 100a. The first pad 122, which is a power pad, may be referred to as a first power pad. The power pad may be configured to be electrically connected to a terminal external to the memory module 100a that supplies power to the memory chip 104 mounted on the first surface 112a of the board 112. For example, a driving voltage for the memory chip 104 may be applied to the power pad. The first pad 122, which is a ground pad, may be referred to as a first ground pad. The ground pad may be configured to be electrically connected to a terminal external to the memory module 100a that provides a ground voltage to the memory chip 104 mounted on the first surface 112a of the board 112. In example embodiments, the first pads 122 may be electrically connected to the vias 116. For example, the first pads 122 may be electrically connected to the conductive lines 114 provided in the board 112 through the vias 116. The first pads 122 and the conductive lines 114 connected by the vias 116 may overlap along the third direction DR3. In example embodiments, the first pads 122 may be electrically connected to the conductive lines 114 provided on the first surface 112a. The first pads 122 provided on the first surface 112a and the conductive lines 114 are electrically connected to each other may overlap along the first direction DR1, the second direction DR2, or a combination of the first direction DR1 and the second direction DR2.

The second pads 124 may be provided on the second surface 112b of the board 112. The second pads 124 may be disposed in the pad region 110b of the module printed circuit board 110. The second pads 124 may include at least one of electrically conductive materials. For example, the second pad 124 may be formed of or include copper (Cu). The second pads 124 may be signal pads, power pads, or ground pads. The second pad 124, which is a signal pad, may be referred to as a second signal pad. The signal pad may be configured to receive an input signal to the memory chip 104, which is mounted on the second surface 112b of the board 112, provided from outside the memory module 100a or to transmit an output signal provided from the memory chip 104, which is mounted on the second surface 112b of the board 112, to the outside of the memory module 100a. The second pad 124, which is a power pad, may be referred to as a second power pad. The power pad may be configured to be electrically connected to a terminal external to the memory module 100a that supplies power to the memory chip 104 mounted on the second surface 112b of the board 112. For example, a driving voltage for the memory chip 104 may be applied to the power pad. The second pad 124, which is a ground pad, may be referred to as a second ground pad. The ground pad may be configured to be electrically connected to a terminal external to the memory module 100a that provides a ground voltage to the memory chip 104 mounted on the second surface 112b of the board 112. In example embodiments, the second pads 124 may be electrically connected to the vias 116. For example, the second pads 124 may be electrically connected to the conductive lines 114 provided in the board 112 through the vias 116. The second pads 124 and the conductive lines 114 connected by the vias 116 may overlap along the third direction DR3. In example embodiments, the second pads 124 may be electrically connected to the conductive lines 114 provided on the second surface 112b. The second pads 124 and the conductive lines 114 provided on the second surface 112b, which are electrically connected to each other, may overlap along the first direction DR1, the second direction DR2, or a combination of the first direction DR1 and the second direction DR2.

Each first pad 122 may be a square or rectangular pad including a pair of first length sides LS1 extending along the first direction DR1 and a pair of first width sides WS1 extending along the second direction DR2. Each first pad 122 may have a first length L1, a first width W1, and a first center line CL1. The first length L1 may be the size of the first pad 122 along the first direction DR1. The first length L1 may be an extension distance of the first length side LS1. The first width W1 may be the size of the first pad 122 along the second direction DR2. The first width W1 may be an extension distance of the first width side WS1. The first center line CL1 may be an imaginary line that passes through the center of the first length side LS1 and extends along the second direction DR2.

Each second pad 124 may be a square or rectangular pad including a pair of second length sides LS2 extending along the first direction DR1 and a pair of second width sides WS2 extending along the second direction DR2. The second pad 124 may have a second length L2, a second width W2, and a second center line CL2. The second length L2 may be the size of the second pad 124 along the first direction DR1. The second length L2 may be an extension distance of the second length side LS2. The second width W2 may be the size of the second pad 124 along the second direction DR2. The second width W2 may be an extension distance of the second width side WS2. The second center line CL2 may be an imaginary line that passes through the center of the second length side LS2 and extends along the second direction DR2.

The first pads 122 and the second pads 124 may have substantially the same shape and size. The first length L1 and the second length L2 may be substantially equal to each other. The first width W1 and the second width W2 may be substantially equal to each other. The first center line CL1 may be spaced apart from the second center line CL2 along the first direction DR1. The first center line CL1 may be closer to a side RS of the board 112 facing a first connector described below than the second center line CL2. Hereinafter, the side RS of the board 112 facing the first connector is referred to as the reference side RS. The distance D11 between the first center line CL1 and the reference side RS may be smaller than the distance D21 between the second center line CL2 and the reference side RS.

The distance D12 between the first pad 122 and the reference side RS may be smaller than the distance D22 between the second pad 124 and the reference side RS. In some example embodiments, the sum of the distance D12 between the first pad 122 and the reference side RS and the first length L1 may be larger than the distance D22 between the second pad 124 and the reference side RS. In some example embodiments, the sum of the distance D12 between the first pad 122 and the reference side RS and the first length L1 may be substantially the same as the distance D22 between the second pad 124 and the reference side RS. In some example embodiments, the sum of the distance D12 between the first pad 122 and the reference side RS and the first length L1 may be smaller than the distance D22 between the second pad 124 and the reference side RS.

The positional relationship between the first width side WS1 and the second width side WS2 is explained in terms of the third direction DR3. One of the pair of first width sides WS1 disposed farther from the chip region 110a may be spaced apart from one of the pair of second width sides WS2 disposed farther from the chip region 110a along the first direction DR1. In some example embodiments, the one of the pair of second width sides WS2 disposed farther from the chip region 110a may be spaced apart from one of the pair of first width sides WS1 disposed closer to the chip region 110a along the first direction DR1. In some example embodiments, the one of the pair of second width sides WS2 disposed farther from the chip region 110a may overlap the one of the pair of first width sides WS1 disposed closer to the chip region 110a. In some example embodiments, one of the pair of first width sides WS1 disposed closer to the chip region 110a may be spaced apart from one of the pair of second width sides WS2 disposed farther from the chip region 110a along the first direction DR1.

The distance D12 between the reference side RS and the one of the pair of first width sides WS1 disposed farther from the chip region 110a may be less than the distance D22 between the one of the pair of second width sides WS2 disposed farther from 110a the chip region and the reference side RS. In example embodiments, the distance D13 between the one of the pair of first width sides WS1 disposed closer to the chip region 110a and the reference side RS may be larger than the distance D22 between the one of the pair of second width sides WS2 disposed farther from the chip region 110a and the reference side RS. In example embodiments, the distance D13 between the one of the pair of first width sides WS1 disposed closer to the chip region 110a and the reference side RS may be substantially equal to the distance D22 between the one of the pair of second width sides WS2 disposed farther from the chip region 110a and the reference side RS. In example embodiments, the distance D13 between the reference side RS and the one of the pair of first width sides WS1 disposed closer to the chip region 110a may be smaller than the distance D22 between the one of the pair of second width sides WS2 disposed farther from the chip region 110a and the reference side RS.

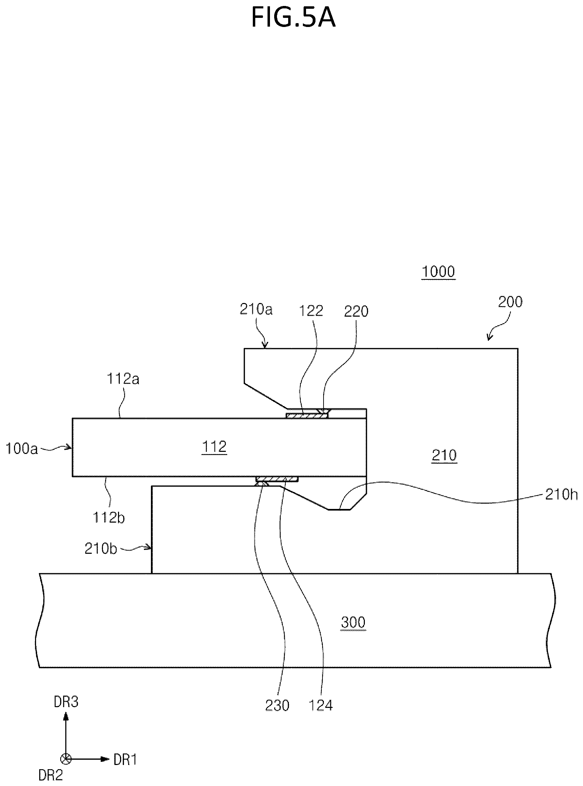

In another example embodiments, the first pads 122 may be configured as the first signal pads. In this case, the first pads 122 may not include the first power pad and the first ground pad. The second pads 124 may be configured as the second power pad and the second ground pad. Some of the second pads 124 may be the second power pads, and others may be the second ground pads. The second pads 124 may not include the second signal pad. One second power pad or one second ground pad may be electrically connected to the plurality of memory chips 104. Before the memory module 100a is connected to the first connector 200 described below, static electricity may accumulate in the first connector 200 and the main printed circuit board 300. When the memory module 100a is connected to the first connector 200, static electricity accumulated in the first connector 200 and the main printed circuit board 300 may flow into the memory module 100a. As will be described later with reference to FIGS. 5A to 5C, the second power pad and the second ground pad may be electrically connected to the first connector 200 before the first signal pad. Since the second power pad and the second ground pad are electrically connected to the plurality of memory chips 104, static electricity may be distributed to the plurality of memory chips 104 through the second power pad and the second ground pad. Accordingly, damage to the memory chips 104 by static electricity can be reduced or substantially prevented.

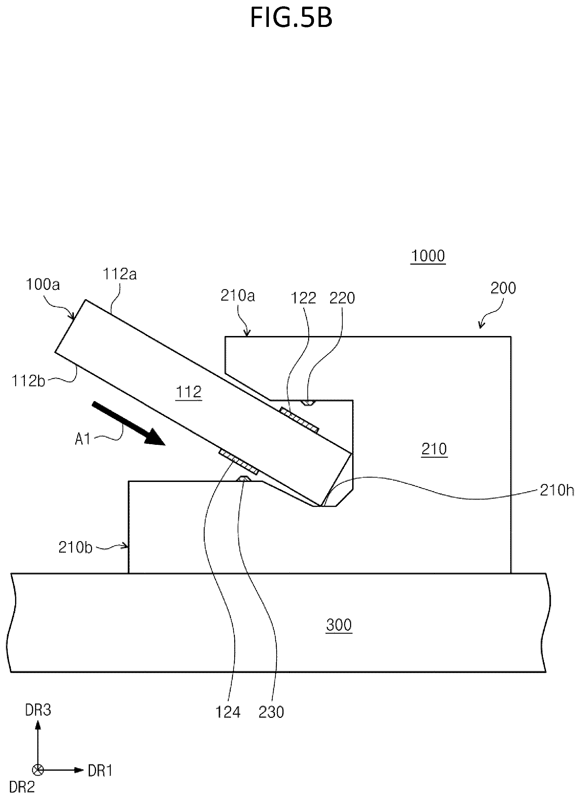

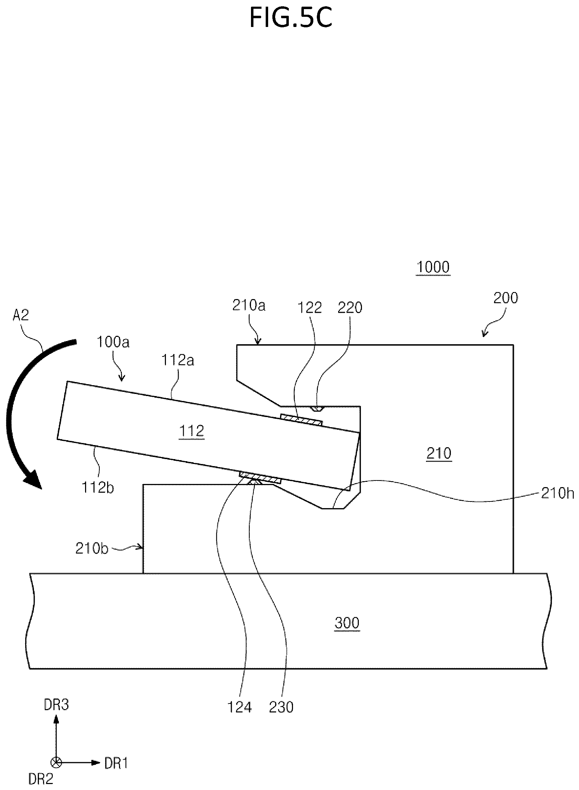

FIG. 5A is a cross-sectional view illustrating an electronic device assembly including the memory module of FIG. 2. FIGS. 5B and 5C are cross-sectional views showing a process in which the memory module of FIG. 5A is mounted on the first connector. For brevity of explanation, content substantially the same as that described with reference to FIGS. 2 to 4 may not be described.

Referring to FIG. 5A, an electronic device assembly 1000 may be provided. The electronic device assembly 1000 may include a main printed circuit board 300, a first connector 200, and a memory module 100a. The memory module 100a may be substantially the same as the memory module 100a described with reference to FIGS. 2 to 4. For brevity of explanation, a board 112, a first pad 122, and a second pad 124 are shown in the memory module 100a. The main printed circuit board 300 may include a board on which components of a computing system may be mounted. The main printed circuit board 300 may include a main conductive line that electrically connects components of the computing system. The main conductive line may be configured to transfer signals and power between components of the computing system of the main printed circuit board 300. Components of the computing system may be attached (e.g., soldered) on the main printed circuit board 300 or embedded in the main printed circuit board 300.

The first connector 200 may be coupled to the main printed circuit board 300. In example embodiments, the first connector 200 may be a SODIMM connector. For example, SODIMM connectors may be used in compact computing systems, such as laptops. The first connector 200 may be provided between the main printed circuit board 300 and the memory module 100a. The first connector 200 may provide an electrical connection between the main printed circuit board 300 and the memory module 100a. The first connector 200 may include a housing 210, first pins 220, and second pins 230. In example embodiments, the first connector 200 may further include fixing members (not shown) for fixing the memory module 100a. For example, fixing members may be provided at both ends of the housing 210 to fix the memory module 100a inserted into the first connector 200.

The housing 210 may be configured to be coupled to the memory module 100a. The housing 210 may extend lengthwise along the second direction DR2. The housing 210 may have the required strength and may include an insulating material. For example, the housing 210 may include insulating plastic. The housing 210 may be configured to surround and support the first pins 220 and the second pins 230. The housing 210 may fix the positions of the first pins 220 and the second pins 230. The housing 210 may include a groove 210h into which the memory module 100a is inserted. The housing 210 may include a first portion 210a facing the first pads 122 and a second portion 210b facing the second pads 124. For example, the first portion 210a may face the first surface 112a of the board 112, and the second portion 210b may face the second surface 112b of the board 112. The first portion 210a and the second portion 210b may be spaced apart from each other with the groove 210h therebetween. The housing 210 may be coupled to the main printed circuit board 300.

The first pins 220 may be inserted into the first portion 210a. The first pins 220 may be arranged along the second direction DR2. The first pins 220 may penetrate the first portion 210a. Ends of the first pins 220 may protrude from the first portion 210a. For example, the first pins 220 may protrude from the bottom of the first portion 210a in a direction opposite to the third direction DR3. The first pins 220 protruding from the first portion 210a may be configured to contact the first pads 122. For example, the first pins 220 may be arranged along the second direction DR2 to correspond to positions of the first pads 122 on the memory module 100a, and each first pin 220 may contact a corresponding one of the first pads 122 when the memory module 100a is inserted into the groove 210h. Accordingly, the first pins 220 and the first pads 122 may be electrically connected to each other. The region where the first pin 220 contacts the first pad 122 may be referred to as a first contact region. Some of the first pins 220 may be signal pins. The signal pins may each be electrically connected to the first signal pads. The signal pins may be configured to transmit an input signal to the memory chips (e.g., memory chips 104 in FIG. 4) to the first signal pads. The signal pins may be configured to receive an output signal provided from the memory chips (e.g., memory chips 104 in FIG. 4) from the first signal pads. Others of the first pins 220 may be power pins. The power pins may be electrically connected to the first power pads, respectively. The power pins may provide power required by the memory chips (e.g., memory chips 104 in FIG. 4) to the first power pads. For example, the power pins may apply a driving voltage to the memory chips (e.g., memory chips 104 in FIG. 4) to the first power pads. Still others of the first pins 220 may be ground pins. The ground pins may each be electrically connected to the first ground pads. The ground pins may be configured to provide the ground voltage required by the memory chips (e.g., memory chips 104 in FIG. 4) to the first ground pads.

The second pins 230 may be inserted into the second portion 210b. The second pins 230 may be arranged along the second direction DR2. From a plan view, the second pins 230 may be spaced apart from the first pins 220 in a direction opposite to the first direction DR1. The second pins 230 may penetrate the second portion 210b. Ends of the second pins 230 may protrude out of the second portion 210b. For example, the second pins 230 may protrude from the top of the second portion 210b along the third direction DR3. Ends of the second pins 230 protruding from the second portion 210b may be configured to contact the second pads 124. For example, the second pins 230 may be arranged along the second direction DR2 to correspond to positions of the second pads 124 on the memory module 100a, and each second pin 230 may contact a corresponding one of the second pads 124 when the memory module 100a is inserted into the groove 210h. Accordingly, the second pins 230 and the second pads 124 may be electrically connected to each other. The region where the second pins 230 contacts the second pads 124 may be referred to as a second contact region. From a perspective along the third direction DR3, the first contact region may be spaced apart from the second contact region along the first direction DR1. Some of the second pins 230 may be signal pins. The signal pins may each be electrically connected to the second signal pads. The signal pins may be configured to apply an input signal to the second signal pads for delivery to the memory chips (e.g., memory chips 104 in FIG. 4). The signal pins may be configured to receive an output signal from the second signal pads and originating from the memory chips (e.g., memory chips 104 in FIG. 4). Others of the second pins 230 may be power pins. The power pins may each be electrically connected to the second power pads. The power pins may provide power required by the memory chips (e.g., memory chips 104 in FIG. 4) to the second power pads. For example, the power pins may apply a driving voltage to the memory chips (e.g., memory chips 104 in FIG. 4) to the second power pads. Still others of the second pins 230 may be ground pins. The ground pins may each be electrically connected to the second ground pads. The ground pins may be configured to provide the ground voltage required by the memory chips (e.g., memory chips 104 in FIG. 4) to the second ground pads.

To couple the memory module 100a to the first connector 200, as shown in FIG. 5B, the memory module 100a may be inserted (indicated as A1) into the groove 210h in an inclined state. Afterwards, as shown in FIG. 5C, the memory module 100a may be rotated (indicated as A2). As the memory module 100a rotates (indicated as A2), the second pads 124 may contact the second pins 230 before the first pads 122 contacts the first pins 220.

When the first pads 122 and the second pads 124 are placed at the same location, the first pads 122 and the second pads 124 may be formed to extend to a region where the first pins 220 and a second pins 230 do not contact, respectively. The first pads 122 and the second pads 124 of the present invention may be disposed at positions corresponding to the first pins 220 and the second pins 230, respectively. Accordingly, the first pads 122 and the second pads 124 may be formed to be small. Since the thickness of the region where the first pads 122 and the second pads 124 are not formed may be as small as the thickness of the first pads 122 and the second pads 124, the memory module 100a may be required less force when inserted into first connector 200. Furthermore, a memory module 100a having improved signal transmission efficiency and improved power transmission efficiency may be provided.

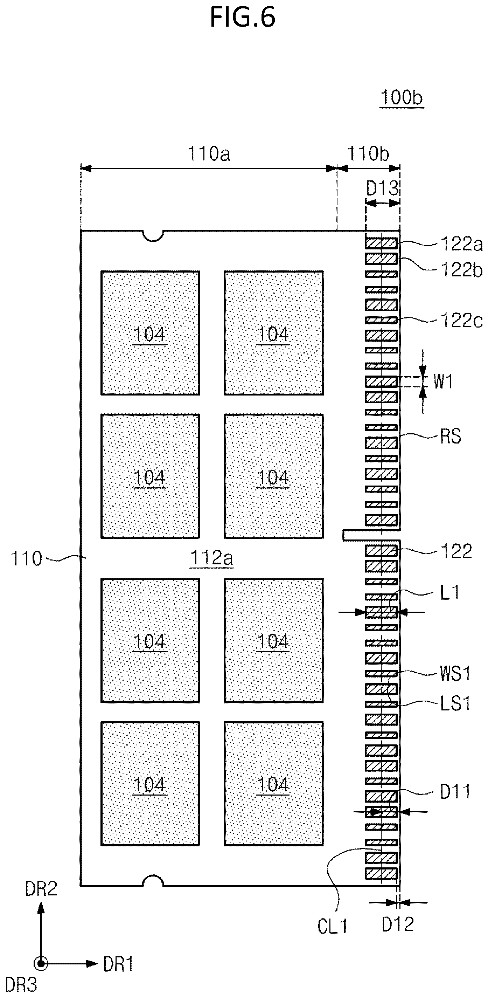

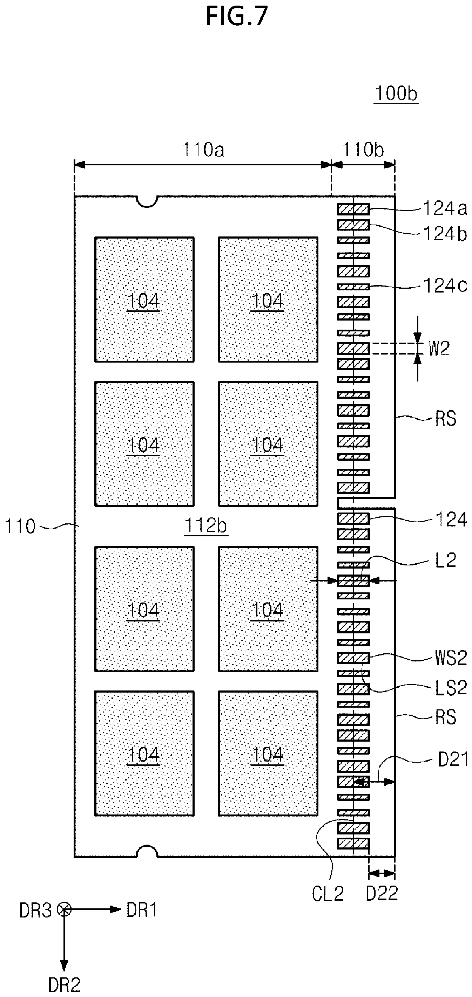

FIG. 6 is a top view of a memory module according to example embodiments. FIG. 7 is a bottom view of the memory module of FIG. 6. For brevity of explanation, differences from those described with reference to FIGS. 2 to 4 are mainly explained, and duplicate descriptions are not repeated.

Referring to FIGS. 6 and 7, a memory module 100b may be provided. First pads 122 may include a first power pad 122a, a first ground pad 122b, and a first signal pad 122c. The first power pad 122a may be one of a plurality of first power pads 122a, the first ground pad 122b may be one of a plurality of first ground pads 122b, and the first signal pad 122c may be one of a plurality of first signal pads 122c. Unlike what is described with reference to FIGS. 2 to 4, from the perspective along the third direction DR3, the first power pad 122a and the first ground pad 122b may have a first width W1 larger than a width in the second direction DR2 of the first signal pad 122c. As the first power pad 122a and the first ground pad 122b have a relatively large first width W1, electrical resistance to power transmission may be reduced. Accordingly, power transmission efficiency can be improved. In example embodiments, the first width W1 of the first power pad 122a and the first width W1 of the first ground pad 122b may be substantially the same. In example embodiments, the first width W1 of the first power pad 122a may be greater than the first width W1 of the first ground pad 122b. In some example embodiments, the first width W1 of the first power pad 122a may be smaller than the first width W1 of the first ground pad 122b. For example, the first width W1 of the first power pad 122a may be smaller than the first width W1 of the first ground pad 122b and greater than the first width W1 of the first signal pad 122c. As the first signal pad 122c has a relatively small first width W1, impedance matching can be achieved between the signal transmission line and the first signal pad 122c. Accordingly, signal reflection can be reduced between the signal transmission line and the first signal pad 122c, thereby improving signal transmission efficiency.

The second pads 124 may include a second power pad 124a, a second ground pad 124b, and a second signal pad 124c. In example embodiments, the second power pad 124a may be a plurality of second power pads 124a, the second ground pad 124b may be a plurality of second ground pads 124b, and the second signal pad 124c may be a plurality of second signal pads 124c. Unlike what is described with reference to FIGS. 2 to 4, from the perspective along the third direction DR3, the second power pad 124a and the second ground pad 124b may have a second width W2 that is larger than a second width W2 of the second signal pad 124c. As the second power pad 124a and the second ground pad 124b have a relatively large second width W2, electrical resistance to power transmission may be reduced. Accordingly, power transmission efficiency can be improved. In some example embodiments, the second width W2 of the second power pad 124a and the second width W2 of the second ground pad 124b may be substantially the same. In some example embodiments, the second width W2 of the second power pad 124a may be greater than the second width W2 of the second ground pad 124b. In some example embodiments, the second width W2 of the second power pad 124a may be smaller than the second width W2 of the second ground pad 124b. For example, the second width W2 of the second power pad 124a may be smaller than the second width W2 of the second ground pad 124b and greater than the second width W2 of the second signal pad 124c. As the second signal pad 124c has a relatively small second width W2, impedance matching can be achieved between the signal transmission line and the second signal pad 124c. Accordingly, signal reflection can be reduced between the signal transmission line and the second signal pad 124c, thereby improving signal transmission efficiency.

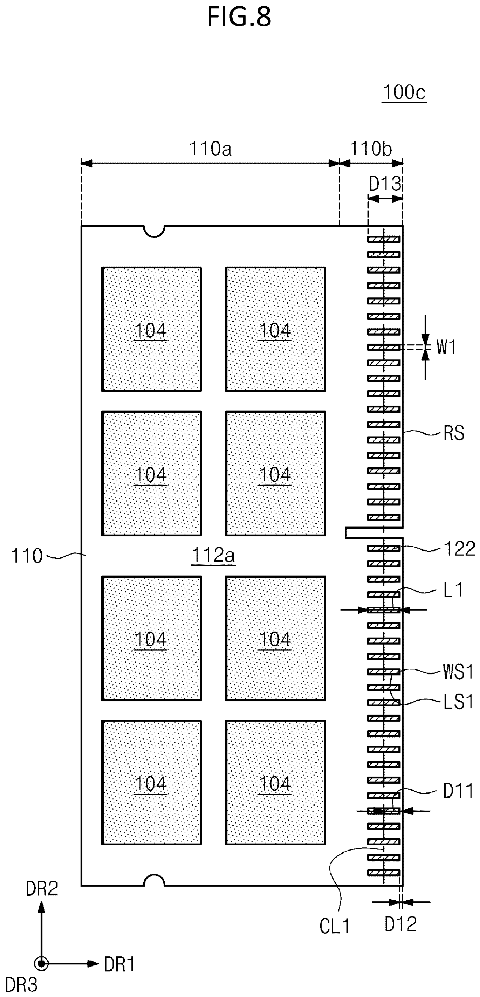

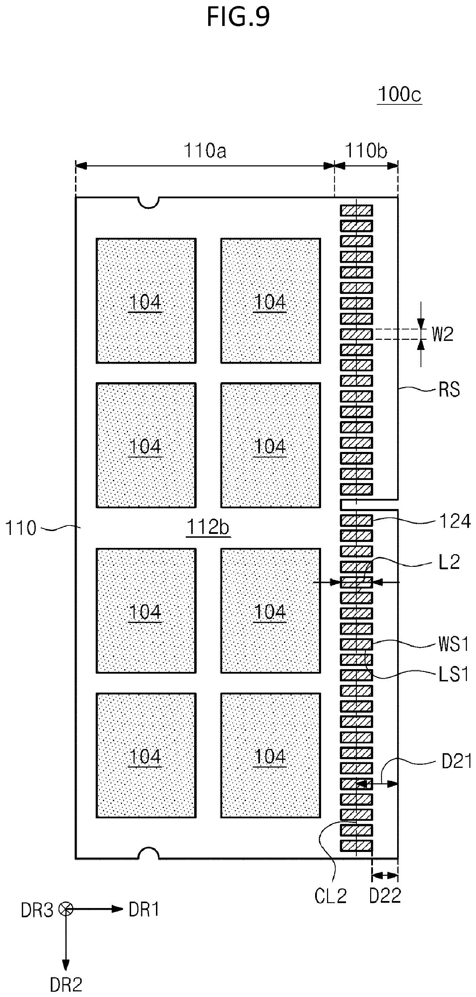

FIG. 8 is a top view of a memory module according to example embodiments. FIG. 9 is a bottom view of the memory module of FIG. 8. For brevity of explanation, differences from those described with reference to FIGS. 2 to 4 are mainly explained, and duplicate descriptions are not repeated.

Referring to FIGS. 8 and 9, a memory module 100c may be provided. Unlike what is described with reference to FIGS. 2 to 4, first pads 122 may be composed of first signal pads. The first pads 122 may not include a first power pad and a first ground pad. Second pads 124 may be composed of a second power pad and a second ground pad. Some of the second pads 124 may be second power pads, and others may be second ground pads. The second pads 124 may not include a second signal pad. The first width W1 of the first pads 122 may be smaller than the second width W2 of the second pads 124. As the first pads 122 (i.e., first signal pad) have a relatively small first width W1, impedance matching can be achieved between the signal transmission line and the first pads 122. Accordingly, signal reflection between the signal transmission line and the first pads 122 is reduced, thereby improving signal transmission efficiency.

One second power pad or one second ground pad may be electrically connected to the plurality of memory chips 104. Before the memory module 100c is connected to the first connector 200, static electricity may accumulate in the first connector 200 and the main printed circuit board 300. When the memory module 100c is connected to the first connector 200, static electricity accumulated in the first connector 200 and the main printed circuit board 300 may flow into the memory module 100c. As described with reference to FIGS. 5A to 5C, the second power pad and the second ground pad may be electrically connected to the first connector 200 before the first signal pad. Since the second power pad and the second ground pad are electrically connected to the plurality of memory chips 104, static electricity may be distributed to the plurality of memory chips 104 through the second power pad and the second ground pad. Accordingly, damage to the memory chip 104 by static electricity can be reduced or substantially prevented.

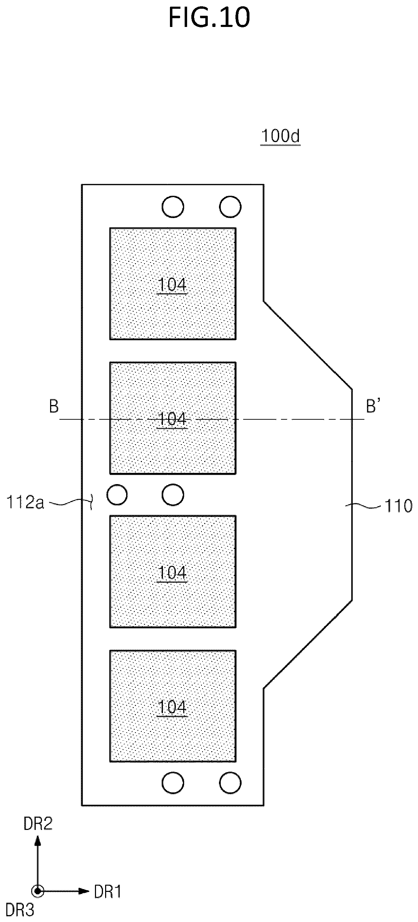

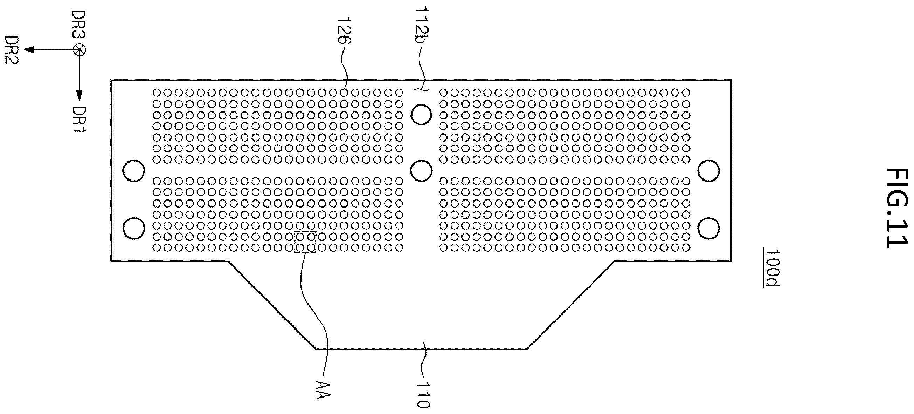

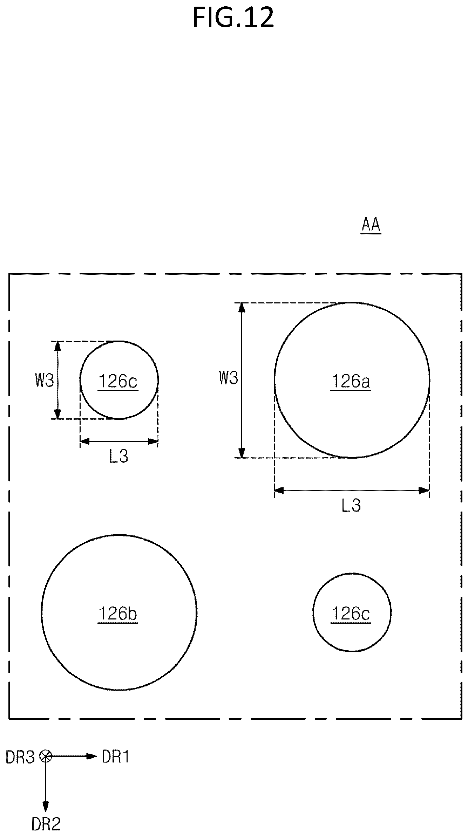

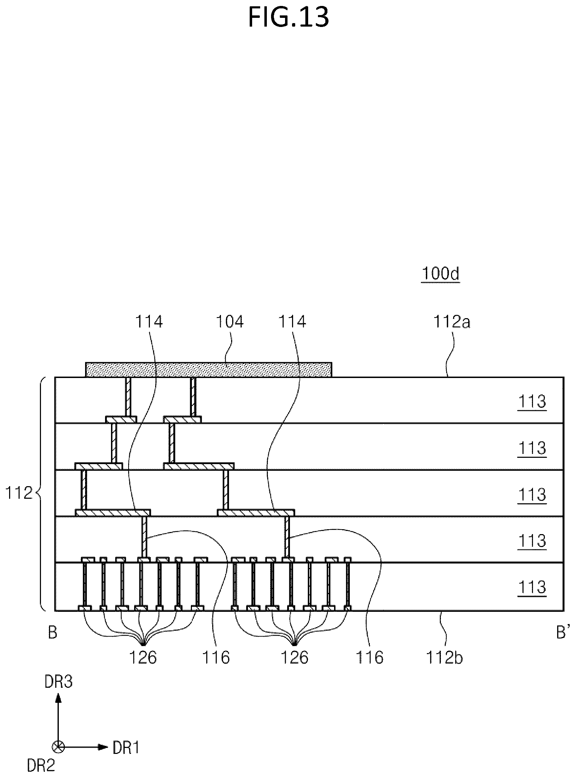

FIG. 10 is a top view of a memory module according to example embodiments. FIG. 11 is a bottom view of a memory module of FIG. 10. FIG. 12 is an enlarged view of portion AA of FIG. 11. FIG. 13 is a cross-sectional view taken along line B-B' in FIG. 10. For brevity of explanation, differences from those described with reference to FIGS. 2 to 4 are mainly explained, and duplicate descriptions are not repeated.

Referring to FIGS. 10 to 13, a memory module 100d may be provided. The memory module 100d may be a CAMM2 with a compression attached memory module (Compression Attached Memory Module) type. The memory module 100d may include a module printed circuit board 110 and memory chips 104. The memory chips 104 may be substantially the same as the memory chips 104 described with reference to FIGS. 2 to 4. The memory module 100d may be coupled to the main printed circuit board 300 described below. The memory module 100d may be arranged parallel to the main printed circuit board 300.

The module printed circuit board 110 may include a board 112, conductive lines 114, vias 116, and third pads 126. The board 112, the conductive lines 114, and the vias 116 may be substantially the same as the board 112, the conductive lines 114, and the vias 116 described with reference to FIGS. 2 to 4. A second surface 112b of the board 112 may face the main printed circuit board 300. A first surface 112a of the board 112 may be disposed opposite to the second surface 112b.

Third pads 126 may be provided on the second surface 112b. Unlike what is described with reference to FIGS. 2 to 4, pads (e.g., first pads 122) may not be provided on the first surface 112a. The third pads 126 may each be electrically connected to third pins 240 described below. For example, the third pads 126 may each contact corresponding third pins. The third pads 126 may overlap the memory chips 104 along the third direction DR3. For example, the third pads 126 may be disposed on the second surface 112b overlapping the memory chips 104 along the third direction DR3. The third pads 126 may have at least one of electrically conductive materials. For example, the third pads 126 may be formed of or include copper (Cu). The third pads 126 may be signal pads, power pads, or ground pads. The third pad 126, which is a signal pad, may be referred to as a third signal pad 126c. The third signal pad 126c may be configured to receive an input signal to the memory chips 104 provided from outside the memory module 100d or to transmit an output signal provided from the memory chips 104 to the outside of the memory module 100d. The third pad 126, which is a power pad, may be referred to as a third power pad 126a. The third power pad 126a may be configured to be electrically connected to a terminal external to the memory module 100d that supplies power to the memory chip 104. For example, the driving voltage for the memory chip 104 may be applied to the third power pad 126a. The third pad 126, which is a ground pad, may be referred to as a third ground pad 126b. The third ground pad 126b may be configured to be electrically connected to a terminal external to the memory module 100d that provides a ground voltage to the memory chip 104. Vias 116 and conductive lines 114 may be provided between the third pads 126 and the memory chips 104. The third pads 126 and the memory chips 104 may be electrically connected by the vias 116 and the conductive lines 114. Although the conductive lines 114 are shown as being provided only within the board 112, this is illustrative. In example embodiments, the third pads 126 may be electrically connected to the conductive lines 114 provided on the first surface 112a or the second surface 112b. The third pads 126 and the conductive lines 114 provided on the first surface 112a or the second surface 112b electrically connected to each other may overlap along the first direction DR1, the second direction DR2, or a combination of the first direction DR1 and the second direction DR2.

Each third pad 126 may have a third length L3 and a third width W3. The third length L3 may be the size of the third pad 126 along the first direction DR1. The third width W3 may be the size of the third pad 126 along the second direction DR2. The third pads 126 may have a desired shape. For example, the third pads 126 may have a circle shape, and each of the third length L3 and the third width W3 may correspond to a diameter of the third pads 126. As shown in FIG. 12, the third power pad 126a and the third ground pad 126b may have a larger region than the third signal pads 126c. In example embodiments, the third power pad 126a and the third ground pad 126b may have substantially the same area. In example embodiments, the third power pad 126a and the third ground pad 126b may have different areas. For example, the third length L3 and the third width W3 of the third power pad 126a and the third ground pad 126b may be larger than the third length L3 and the third width W3 of the third signal pad 126c.

As the third power pads 126a and the third ground pads 126b have relatively large areas, electrical resistance to power transmission may be reduced. Accordingly, power transmission efficiency can be improved. As the third signal pads 126c each have a relatively small area, impedance matching can be achieved between the signal transmission line and the third signal pads 126c. Accordingly, signal reflection can be reduced between the signal transmission line and the third signal pads 126c, thereby improving signal transmission efficiency.

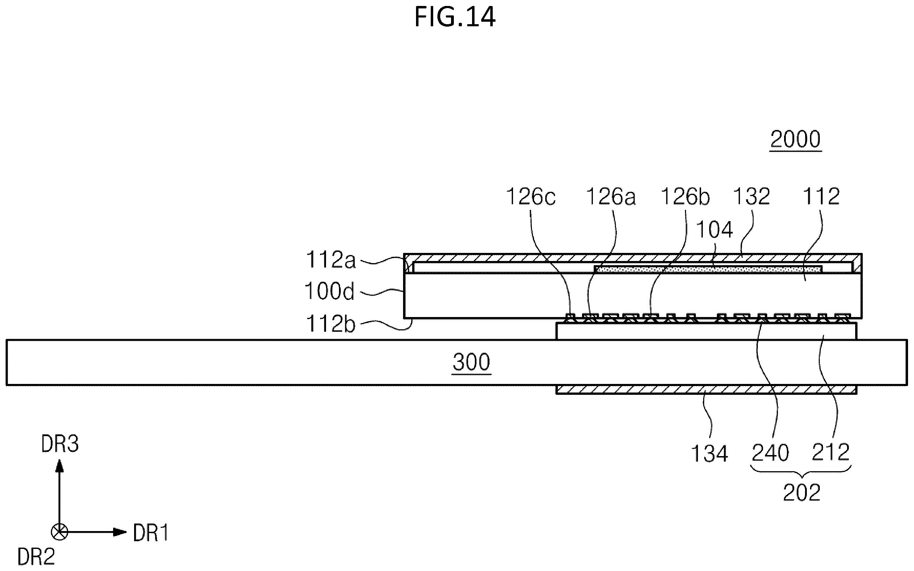

FIG. 14 is a cross-sectional view for illustrating an electronic device including the memory module of FIG. 10. For brevity of explanation, content that is substantially the same as that described with reference to FIGS. 5A to 5C and to that described with reference to FIGS. 10 to 13 may not be repeated.

Referring to FIG. 14, an electronic device assembly 2000 may be provided. The electronic device assembly 2000 may include a main printed circuit board 300, a memory module 100d, a second connector 202, a cover plate 132, and a back plate 134. The main printed circuit board 300 may be substantially the same as the main printed circuit board 300 described with reference to FIGS. 5A to 5C. The memory module 100d may be substantially the same as the memory module 100d described with reference to FIGS. 10 to 13.

The second connector 202 may be coupled to the main printed circuit board 300. The second connector 202 may be a CAMM2 connector. For example, the CAMM2 connector may be used in compact computing systems, such as laptops. The second connector 202 may be provided between the main printed circuit board 300 and the memory module 100d. The second connector 202 may provide an electrical connection between the main printed circuit board 300 and the memory module 100d. The second connector 202 may include a housing 212 and third pins 240.

The housing 212 may be disposed between the board 112 and the main printed circuit board 300. For example, the upper surface of the housing 212 may face the second surface 112b. The housing 212 may extend lengthwise along the second direction DR2. The housing 212 may have the required strength and include at least one of insulating materials. For example, the housing 212 may be formed of or include insulating plastic. The housing 212 may be configured to surround and support the third pins 240. The housing 212 may fix the positions of the third pins 240. The third pins 240 may be placed at required positions on the upper surface of the housing 212. For example, each of the third pins 240 may be arranged to correspond to positions of the third pads 126 on the memory module 100d, and each third pin 240 may contact a corresponding one of the third pads 126 when the memory module 100d is connected to the housing 212.

Some of the third pins 240 may be signal pins. The signal pins may each be electrically connected to third signal pads (e.g., third signal pads 126c in FIG. 11). The signal pins may be configured to transmit an input signal for the memory chip 104 to third signal pads (e.g., third signal pads 126c in FIG. 11). The signal pins may be configured to receive an output signal provided from the memory chip 104 from third signal pads (e.g., third signal pads 126c in FIG. 11). Others of the third pins 240 may be power pins. The power pins may each be electrically connected to third power pads (e.g., third power pads 126a in FIG. 11). The power pins may provide power required by the memory chip 104 to third power pads (e.g., third power pads 126a in FIG. 11). For example, the power pins may apply a driving voltage for the memory chip 104 to third power pads (e.g., third power pads 126a in FIG. 11). Still others of the third pins 240 may be ground pins. The ground pins may each be electrically connected to third ground pads (e.g., third ground pads 126b in FIG. 11). The third ground pads (e.g., third ground pads 126b in FIG. 11) may be configured to be electrically connected to provide a ground voltage required by the memory chip 104.

The cover plate 132 may be provided on the memory module 100d. The memory module 100d may be disposed between the cover plate 132 and the second connector 202. The back plate 134 may be provided below the main printed circuit board 300. The main printed circuit board 300 may be disposed between the back plate 134 and the second connector 202. The cover plate 132 and the back plate 134 may be screwed together. The cover plate 132 and the back plate 134 may be configured to bring the memory module 100d, the second connector 202, and the main printed circuit board 300 into close contact with each other and increase the coupling force therebetween.

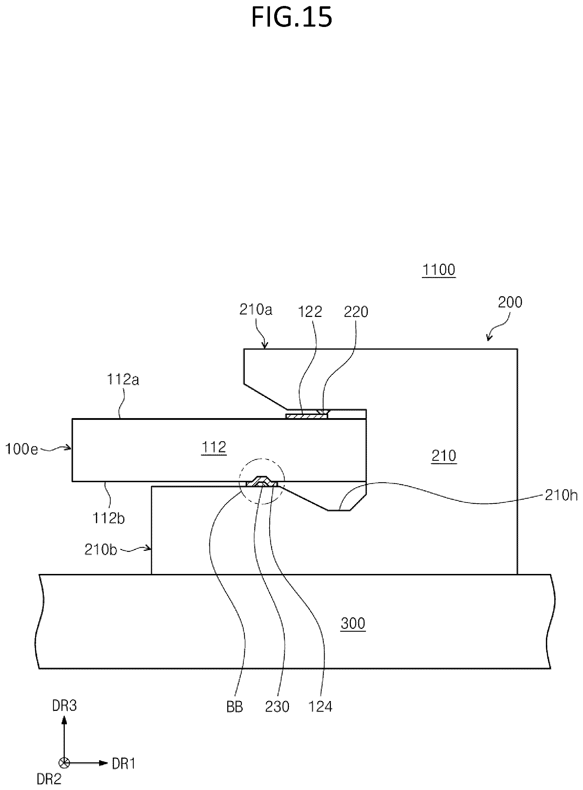

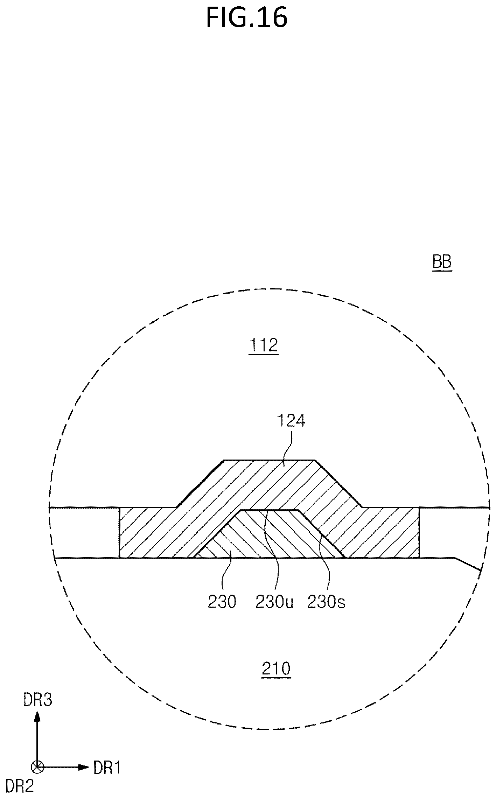

FIG. 15 is a cross-sectional view for illustrating an electronic device according to example embodiments. FIG. 16 is an enlarged view of portion BB in FIG. 15. For brevity of explanation, differences from those described with reference to FIG. 5A are explained, and duplicate descriptions will not be repeated.

Referring to FIGS. 15 and 16, an electronic device assembly 1100 may be provided. The electronic device assembly 1100 may include a main printed circuit board 300, a memory module 100e, and a first connector 200. The memory module 100e may be substantially the same as the memory module 100a described with reference to FIGS. 2 to 4 except for the second pads 124. For brevity of explanation, a board 112, a first pad 122, and a second pad 124 are shown in the memory module 100e. The second pads 124 of the memory module 100e may be inserted into the board 112. The surface of the second pads 124 facing the second portion 210b of the housing 210 may have a concave shape. For example, the second pads 124 may have a first portion on a surface of the board 112 and a second portion recessed into the board 112.

The second pins 230 may be inserted into the concave surfaces of the second pads 124. The top surface 230u and the side surface 230s of the second pins 230 may contact the second pads 124. For example, the second pins 230 may fully contact the concave portion of the second pads 124. In example embodiments, the second pads 124 may be comprised of power pads and ground pads.

The present disclosure may provide the electronic device assembly 1100 in which power or ground voltage can be stably supplied to a memory chip (e.g., memory chip 104 in FIG. 4) by contacting the second pads 124 not only with the top surface 230u but also with the side surface 230s of the second pins 230. For example, by contacting the second pads 124 with the top surface 230u and the side surface 230s of the second pins 230, electrical resistance to power transmission may be reduced.

According to the present disclosure, a memory module and electronic device assembly with improved characteristics may be provided.

While the present disclosure has been described with reference to embodiments thereof, it will be apparent to those of ordinary skill in the art that various changes and modifications may be made thereto without departing from the scope of the present disclosure as set forth in the following claims.

### ANNEX A

1. A memory module comprising:
   a module printed circuit board including a chip region and a pad region; and
   a memory chip provided on the module printed circuit board,
   wherein the module printed circuit board includes, a board including a first surfaces and a second surface disposed opposite to each other, a first pad provided on the first surface, and a second pad provided on the second surface,
   wherein the first pad is disposed farther from the chip region than the second pad.
2. The memory module of paragraph 1, wherein the first pad is disposed at a position shifted from the second pad along an arrangement direction of the chip region and the pad region.
3. The memory module of paragraph 1 or paragraph 2, wherein the first pad has a pair of first width sides extending along a second direction intersecting a first direction parallel to an arrangement direction of the chip region and the pad region,
   wherein the second pad has a pair of second width sides extending along the second direction,
   wherein the board is disposed in the pad region and has a reference side extending along the second direction, and
   wherein the distance between one of the pair of first width sides adjacent to the reference side and the reference side is smaller than the distance between one of the pair of second width sides adjacent to the reference side.
4. The memory module of paragraph 3, wherein a first center line extending along the second direction and passing through the center of the first pad is spaced apart from a second center line extending along the second direction and passing through the center of the second pad along the first direction.
5. The memory module of paragraph 3 or paragraph 4, wherein the distance between one of the pair of first width sides disposed farther from the reference side and the reference side is different from the distance between one of the pair of second width sides adjacent to the reference side and the reference side.
6. The memory module of any of paragraphs 3 to 5, wherein the distance between one of the pair of first width sides disposed farther from the reference side and the reference side is the same as the distance between one of the pair of second width sides adjacent to the reference side and the reference side.
7. The memory module of any of paragraphs 1 to 6,
   wherein the first pad is provided in plural,
   wherein the plurality of first pads include a first power pad, a first ground pad, and a first signal pad,
   wherein the width of the first power pad and the first ground pad is greater than the width of the first signal pad.
8. The memory module of paragraph 7, wherein a width of the first power pad is different from a width of the first ground pad.
9. The memory module of paragraph 7 or paragraph 8, wherein a width of the first power pad is the same as a width of the first ground pad.
10. The memory module of any of paragraphs 7 to 9,
   wherein the second pad is provided in plural,
   wherein the plurality of second pads include a second power pad, a second ground pad, and a second signal pad,
   wherein a width of the second power pad and the second ground pad is greater than a width of the second signal pad.
11. The memory module of any of paragraphs 1 to 10,
   wherein the first pad is provided in plural pieces,
   wherein the second pad is provided in plural,
   wherein the plurality of first pads have a width smaller than that of the plurality of second pads.
12. An electronic device assembly comprising:
   a main printed circuit board;
   a memory module; and
   a connector provided between the main printed circuit board and the memory module,
   wherein the memory module includes a module printed circuit board including a chip region and a pad region, and a memory chip provided on the module printed circuit board,
   wherein the module printed circuit board includes a first surface provided on an opposite side of the main printed circuit board and a second surface facing the main printed circuit board, and a plurality of first pads provided on the first surface, and a plurality of second pads provided on the second surface,
   wherein the plurality of first pads is disposed farther from the chip region than the plurality of second pads.
13. The electronic device assembly of paragraph 12, wherein the connector includes a housing, a plurality of first pins inserted into an upper part of the housing, and a plurality of second pins inserted into a lower part of the housing,
   wherein the plurality of first pins protrude from the upper part of the housing and are electrically connected to the plurality of first pads, and
   wherein the plurality of second pins protrude from the upper part of the housing and are electrically connected to the plurality of second pads.
14. The electronic device assembly of paragraph 13, wherein, when viewed along a direction perpendicular to the first surface, the plurality of first fins are positioned shifted from the plurality of second fins in a direction parallel to an arrangement direction of the chip region and the pad region.
15. The electronic device assembly of paragraph 13 or paragraph 14, wherein, from a perspective along a direction perpendicular to the first surface, first contact regions where the plurality of first pins and the plurality of first pads are in contact are spaced apart from second contact regions where the plurality of second pins and the plurality of second pads are in contact in a direction parallel to an arrangement direction of the chip region and the pad region.
16. The electronic device assembly of any of paragraphs 12 to 15, wherein the plurality of first pads include a first power pad, a first ground pad, and a first signal pad, and
   wherein a width of the first power pad and the first ground pad is greater than a width of the first signal pad.
17. The electronic device assembly of paragraph 16, wherein the plurality of second pads include a second power pad, a second ground pad, and a second signal pad, and a width of the second power pad and a width of the second ground pad is greater than a width of the second signal pad.
18. The electronic device assembly of any of paragraphs 12 to 17, wherein the plurality of first pads have a smaller width than the plurality of second pads.
19. The electronic device assembly of paragraph 18, wherein the plurality of first pads are signal pads,
   wherein some of the plurality of second pads are power pads, and others of the plurality of second pads are ground pads.
20. A memory module comprising:
   a board having a first surface and a second surface disposed opposite each other;
   a memory chip provided on the first surface; and
   a plurality of first pads provided on the second surface and overlapping the memory chip along an arrangement direction of the first surface and the second surface,
   wherein some of the plurality of first pads have a smaller area than other portions of the first pads.

## Claims

1. A memory module comprising:
a module printed circuit board including a chip region and a pad region; and
a memory chip provided on the module printed circuit board in the chip region,
wherein the module printed circuit board includes a board including a first surface and a second surface disposed opposite to each other, a first pad provided on the first surface in the pad region, and a second pad provided on the second surface in the pad region, and
wherein the first pad is disposed farther from the chip region than the second pad.

2. The memory module of claim 1, wherein the first pad is disposed at a position shifted from the second pad along an arrangement direction of the chip region and the pad region.

3. The memory module of claim 1 or claim 2,
wherein the first pad has a pair of first width sides extending along a second direction intersecting a first direction parallel to an arrangement direction of the chip region and the pad region,
wherein the second pad has a pair of second width sides extending along the second direction,
wherein the board is disposed in the pad region and has a reference side extending along the second direction, and
wherein a distance between one of the pair of first width sides adjacent to the reference side and the reference side is smaller than a distance between one of the pair of second width sides adjacent to the reference side and the reference side.

4. The memory module of claim 3, wherein a first center line extending along the second direction and passing through the center of the first pad is spaced apart in the first direction from a second center line extending along the second direction and passing through the center of the second pad.

5. The memory module of claim 3 or claim 4, wherein the distance between one of the pair of first width sides disposed farther from the reference side and the reference side is different from the distance between one of the pair of second width sides adjacent to the reference side and the reference side.

6. The memory module of any preceding claim, comprising a plurality of pads on the first surface, the plurality of pads including the first pad,
wherein the plurality of pads include a first power pad, a first ground pad, and a first signal pad, and
wherein a width of the first power pad and a width of the first ground pad are greater than a width of the first signal pad.

7. The memory module of any preceding claim, comprising:
a plurality of pads on the first surface including the first pad;
a further plurality of pads on the second surface including the second pad,
wherein each of the plurality of pads on the first surface has a width smaller than a width of each of the further plurality of pads on the second surface.

8. An electronic device assembly comprising:
a main printed circuit board;
the memory module of any preceding claim; and
a connector provided between the main printed circuit board and the memory module,
wherein the second surface of the module printed circuit board faces the main printed circuit board, the module printed circuit board including:
a plurality of pads provided on the first surface in the pad region and including the first pad; and
a further plurality of pads provided on the second surface in the pad region and including the second pad, and
wherein the plurality of pads on the first surface is disposed farther from the chip region than the further plurality of pads on the second surface.

9. The electronic device assembly of claim 8,
wherein the connector includes a housing, a plurality of first pins inserted into an upper part of the housing, and a plurality of second pins inserted into a lower part of the housing,
wherein the plurality of first pins protrude from the upper part of the housing and are electrically connected to the plurality of pads on the first surface, and
wherein the plurality of second pins protrude from the lower part of the housing and are electrically connected to the further plurality of pads on the second surface.

10. The electronic device assembly of claim 9, wherein, when viewed along a direction perpendicular to the first surface, the plurality of first pins are positioned shifted from the plurality of second pins in a direction parallel to an arrangement direction of the chip region and the pad region.

11. The electronic device assembly of claim 9, wherein, from a perspective along a direction perpendicular to the first surface, first contact regions where the plurality of first pins and the plurality of pads on the first surface are in contact are spaced apart from second contact regions where the plurality of second pins and the further plurality of pads on the second surface are in contact in a direction parallel to an arrangement direction of the chip region and the pad region.

12. The electronic device assembly of claim 8,
wherein the plurality of pads on the first surface include a first power pad, a first ground pad, and a first signal pad, and
wherein a width of the first power pad and a width of the first ground pad are greater than a width of the first signal pad.

13. The electronic device assembly of claim 12,
wherein the further plurality of pads on the second surface include a second power pad, a second ground pad, and a second signal pad, and
wherein a width of the second power pad and a width of the second ground pad are greater than a width of the second signal pad.

14. The electronic device assembly of claim 8, wherein each of the plurality of pads on the first surface has a width smaller than a width of each of the plurality of pads on the second surface.

15. The electronic device assembly of claim 14,
wherein the plurality of pads on the first surface are signal pads, and
wherein some of the further plurality of pads on the second surface are power pads, and others of the further plurality of pads on the second surface are ground pads.
